# EUROPEAN PATENT APPLICATION

(11) **EP 3 276 658 A1**
(43) Date of publication of application: **31.01.2018**
(21) Application number: 16181358.9
(22) Date of filing: 27.07.2016
(51) Int. Cl.: H01L 23/473

(54) **COOLER, POWER SEMICONDUCTOR MODULE ARRANGEMENT WITH A COOLER AND METHODS FOR PRODUCING THE SAME**

(71) Applicant: Infineon Technologies AG, 85579 Neubiberg (DE)
(72) Inventor: JONES, Patrick, 59494 Soest (DE)
(74) Representative: Westphal, Mussgnug & Partner Patentanwälte mbB

(57) **Abstract**

A cooler includes a cavity for receiving a cooling fluid, an inlet opening for supplying the cooling fluid to the cavity, and an outlet opening for discharging the cooling fluid from the cavity. The cavity has, in each of all sectional planes perpendicularly intersecting a segment of a straight line running through both the inlet opening and the outlet opening, a boundary line formed as a closed loop and having an individual perimeter length. A maximum value of the perimeter lengths is greater than a minimum value of the perimeter lengths and less than twice the minimum value of the perimeter lengths.

## Description

### TECHNICAL FIELD

The instant disclosure relates to coolers, in particular to coolers for cooling power semiconductor modules, to a power semiconductor module arrangement with a cooler, and to a method for producing a power semiconductor module with a cooler.

### BACKGROUND

Many technical fields like the field of power semiconductor modules requires efficient cooling of diverse devices. The high power densities required for today power semiconductor module applications require that the heat generated in the module is dissipated to a cooler. Often, fluid coolers with a fluid coolant flowing through the cooler are used as such coolers excellently dissipate the heat. Such a fluid cooler includes a cavity for receiving the coolant, an inlet for supplying the coolant to the cavity, and an outlet for discharging the coolant from the cavity. As the coolant is passing through the cooler between the inlet and the outlet, the coolant experiences an undesired but unavoidable pressure drop. In principle, the pressure drop can be reduced by reducing the flow resistance of the cooler. This, however, is regarded to reduce the cooling efficiency. Hence, there is a general need for a cooler having both a high cooling efficiency and a low flow resistance. Further, there is a need for a power semiconductor module arrangement that includes a cooler having both a high cooling efficiency and a low flow resistance, and for a method of producing such a power semiconductor module arrangement.

### SUMMARY

A cooler includes a cavity configured to receive a cooling fluid, an inlet opening configured to supply the cooling fluid to the cavity, and an outlet opening for discharging the cooling fluid from the cavity. In each of all sectional planes perpendicularly intersecting a segment of a straight line running through both the inlet opening and the outlet opening, the cavity includes a boundary line formed as a closed loop and having an individual perimeter length. A maximum value of the perimeter lengths is greater than a minimum value of the perimeter lengths and less than twice the minimum value of the perimeter lengths.

A power semiconductor module arrangement includes a cooler, and a semiconductor chip attached to a contact surface of the cooler. The cooler includes a cavity for receiving a cooling fluid, an inlet opening for supplying the cooling fluid to the cavity, and an outlet opening for discharging the cooling fluid from the cavity. In each of all sectional planes perpendicularly intersecting a segment of a straight line running through both the inlet opening and the outlet opening, the cavity includes a boundary line formed as a closed loop and having an individual perimeter length. A maximum value of the perimeter lengths is greater than a minimum value of the perimeter lengths and less than twice the minimum value of the perimeter lengths.

A method for producing a power semiconductor module arrangement includes attaching a semiconductor chip to the base plate. Subsequently, a first part and the base plate are joined to one another so that the base plate is a part of a cooler. The cooler includes a cavity for receiving a cooling fluid, an inlet opening for supplying the cooling fluid to the cavity, and an outlet opening for discharging the cooling fluid from the cavity. In each of all sectional planes perpendicularly intersecting a segment of a straight line running through both the inlet opening and the outlet opening, the cavity includes a boundary line formed as a closed loop and having an individual perimeter length. A maximum value of the perimeter lengths is greater than a minimum value of the perimeter lengths and less than twice the minimum value of the perimeter lengths.

The cooler, the power semiconductor module arrangement and the method for producing the power semiconductor module arrangement may be better understood with reference to the following drawings and description. The features in the figures are not necessarily to scale, emphasis instead being placed upon illustrating the principles of the invention. Moreover, in the figures, like referenced numerals designate corresponding parts throughout the different views.

### BRIEF DESCRIPTION OF THE DRAWINGS

Figure 1 is an isometric view illustrating an exemplary cooler.
Figure 2 is a side view illustrating the cooler shown in Figure 1.
Figure 3 is a longitudinal-sectional view illustrating the cooler shown in Figure 1 in a sectional plane perpendicular to a straight line running through both an input opening and an output opening of the cooler.
Figure 4 is a further side view illustrating the cooler shown in Figure 1.
Figure 5 is a cross-sectional view illustrating the cooler shown in Figure 1.
Figure 6 is a cross-sectional view illustrating a sectional plane S1-S1 of the cooler shown in Figure 3.
Figure 7 is a cross-sectional view illustrating a sectional plane S2-S2 of the cooler shown in Figure 3.
Figure 8 is a cross-sectional view illustrating a sectional plane S3-S3 of the cooler shown in Figure 3.
Figure 9 is a cross-sectional side view illustrating an example power semiconductor module arrangement that includes the cooler shown in Figure 1.
Figure 10 is side view is illustrating a method for manufacturing the power semiconductor module arrangement of Figure 9.
Figure 11 is a top view illustrating a further example power semiconductor module arrangement.
Figure 12 is a side view illustrating the power semiconductor module arrangement shown in Figure 11.
Figure 13 is a first cross-sectional view illustrating the power semiconductor module arrangement shown in Figure 11 in a sectional plane E1-E1.
Figure 14 is a second cross-sectional view illustrating the power semiconductor module arrangement shown in Figure 11 in a sectional plane E2-E2.
Figure 15 is a side view illustrating the power semiconductor module of the power semiconductor module arrangement shown in Figure 11.
Figure 16 is a bottom view illustrating the power semiconductor module of the power semiconductor module arrangement shown in Figure 11.
Figure 17 is an isometric view illustrating the power semiconductor module of the power semiconductor module arrangement shown in Figure 11.
Figure 18 is an isometric view illustrating another power semiconductor module.
Figure 19 shows several cross-sectional views of the base plates of the power semiconductor modules shown in Figures 15 to 18.
Figure 20 is a cross-sectional view illustrating a cross section of the cooler shown in Figure 1.
Figure 21 is a cross-sectional view illustrating a cross section of a second part of a cooler.

### DETAILED DESCRIPTION

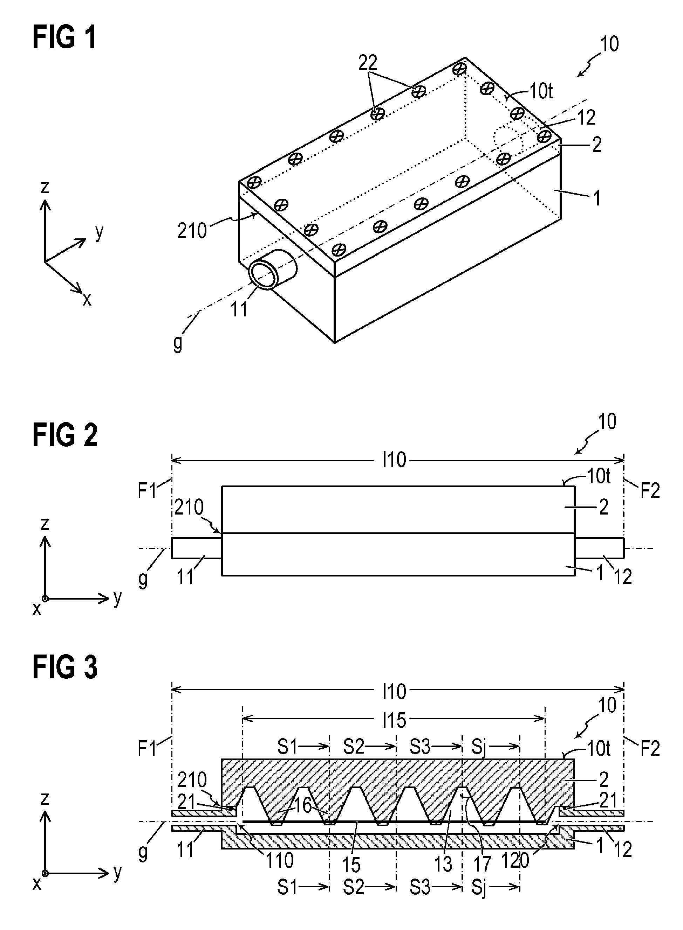

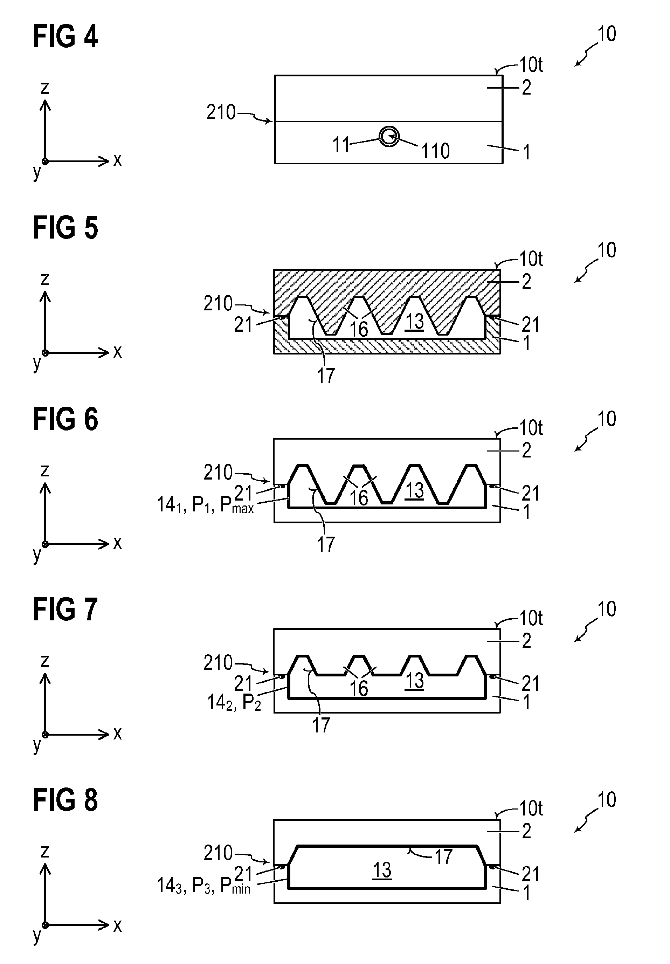

Figures 1 to 5 schematically illustrate an exemplary cooler 10. Figure 1 is an isometric view, Figure 2 is a side view, Figure 3 is a cross-sectional view, Figure 4 is a further side view, and Figure 5 is a further cross-sectional view. In Figures 2 and 3, the line of vision is the same (the negative x-axis). In Figures 4 and 5, the line of vision is the same (the positive y-axis). The coordinate system illustrated in all Figures is an orthogonal coordinate system

The cooler 10 includes a cavity 13 for receiving a cooling fluid, an inlet 11 with an inlet opening 110 for supplying a cooling fluid, e.g. a liquid or a gas, to the cavity 13, an outlet 12 with an outlet opening 120 for discharging the cooling fluid from the cavity 13, and a contact surface 10t which can be brought into thermal contact with a device to be cooled.

Next, the geometry of the cavity 13 or at least a section of the cavity 13 will be described with reference to Figures 3 and 6 to 8. On a (mathematical, i.e. virtual) straight line g running through both the inlet opening 110 and the outlet opening 120, a (mathematical, i.e. virtual) segment 15 of the straight line g located inside the cavity 13 can be defined. In Figure 3, the segment 15 is illustrated as a bold line. The length of the segment 15 is designated with 115. For instance, the length 115 may be at least 10 mm length, and/or at least 20% of the length 110 the cooler 10 has in the direction of the straight line g. The length 110 of the cooler 10 is the minimum distance two parallel planes F1 and F2 running perpendicular to the straight line g with the cooler 10 disposed in between may have.

In each of all sectional planes (Figure 3 exemplarily illustrates sectional planes S₁, S₂, S₃ representative of the infinite number of sectional planes) perpendicularly intersecting the (same) segment 15, the cavity 13 has a respective boundary line 14₁, 14₂, 14₃ limiting the cavity 13 in the respective sectional plane S₁, S₂, S₃. Figure 6 illustrates the cross-section of sectional plane S₁ and the associated boundary line 14₁, Figure 7 illustrates the cross-section of sectional plane S₂ and the associated boundary line 14₂, and Figure 8 illustrates the cross-section of sectional plane S₃ and the associated boundary line 14₃, as a bold line in each case. Each boundary line 14₁, 14₂, 14₃ is formed as a closed loop. The boundary line 14₁ has a perimeter length P₁, the boundary line 14₂ has a perimeter length P₂, and the boundary line 14₃ has a perimeter length P₃. In the same manner, to each of all sectional planes S₁, S₂, S₃,... perpendicularly intersecting the segment 15 an associated boundary line 14₁, 14₂, 14₃,... limiting the cavity 13, formed a closed loop and having a perimeter length P₁, P₂, P₃,... can be assigned. With Pₘᵢₙ being the minimum value of the all these perimeter lengths P₁, P₂, P₃,... and Pₘₐₓ being the maximum value of all these perimeter lengths P₁, P₂, P₃,..., the cooler 10 is designed such that it fulfils the relation Pₘᵢₙ < Pₘₐₓ < 2·Pₘᵢₙ.

In the illustrated example, the minimum value Pₘᵢₙ is given by P₃, and the maximum value Pₘₐₓ is given by P₁. According to the investigations of the inventor of the present invention, the above relation provides for both a high cooling efficiency and a low pressure drop of the cooling fluid caused by the cooler 10.

As illustrated in Figures 1 to 8, the cooler 10 may have a first part 1 and a second part 2 joined to one another so that both the first part 1 and the second part 2 limit the cavity 13. In this sense, a part "limits" the cavity 13 if the cavity extends as far as the part. Optionally, the first part 1 may be tub-shaped.

Assembling the cooler 10 from two (or more) parts 1, 2 limiting the cavity 13 may facilitate the manufacturing of the cooler 10. For joining the first part 1 and the second part 2, an arbitrary suitable joining technique, for instance screwing, clipping, crimping, soldering, brazing, sintering, welding, may be used. As an example for a joining technique, Figure 1 exemplarily shows several screws 22. However, instead of or in addition to screwing, any other suitable joining technique may be used as well. The first part 1 and the second part 2 may be made of the same material or of different materials, whereby the expression "material" is intended to not only include pure materials like metals (e.g. copper, aluminium) but also homogeneous material compositions like an alloy, a ceramic, or a metal-matrix-composite material (e.g. aluminium silicon carbide).

In principle, however, the cooler 10 may be made of one piece, i.e. without a pre-fabricated first part 1 limiting the cavity 13 joined to a pre-fabricated second part 2 limiting the cavity 13. A suitable method for fabricating such a cooler 10 is, for instance, additive manufacturing, e.g. selective laser sintering, direct metal laser sintering, selective laser melting, robocasting, may be used.

In case of a cooler 10 that is assembled by joining prefabricated first and second parts 1, 2, the joint between the first part 1 and the second part 2 may be formed to be hermetically tight in order to prevent a cooling fluid inside the cavity 13 from flowing out of the cavity 13 through a gap 210 between the first part 1 and the second part 2. If the joining technique used for joining the first part 1 and the second part 2 causes a non-material-locking joint (e.g. screwing, clipping, crimping), a gasket 21 may be inserted between the first part 1 and the second part 2 in order to hermetically seal the gap 210 between the first part 1 and the second part 2. Figures 3 to 8 exemplarily show such a gasket 21. As a gasket 21, any type of gasket allowing for hermetically sealing the gap 210 may be used, for instance, an O-ring gasket, a flat gasket, or any other suitable type of gasket. Optionally, the gasket 21 may have the shape of a closed ring. Instead of one and only one gasket 21, two or more than two gaskets 21 may be used for hermetically sealing a gap 210 between the first part 1 and the second part 2.

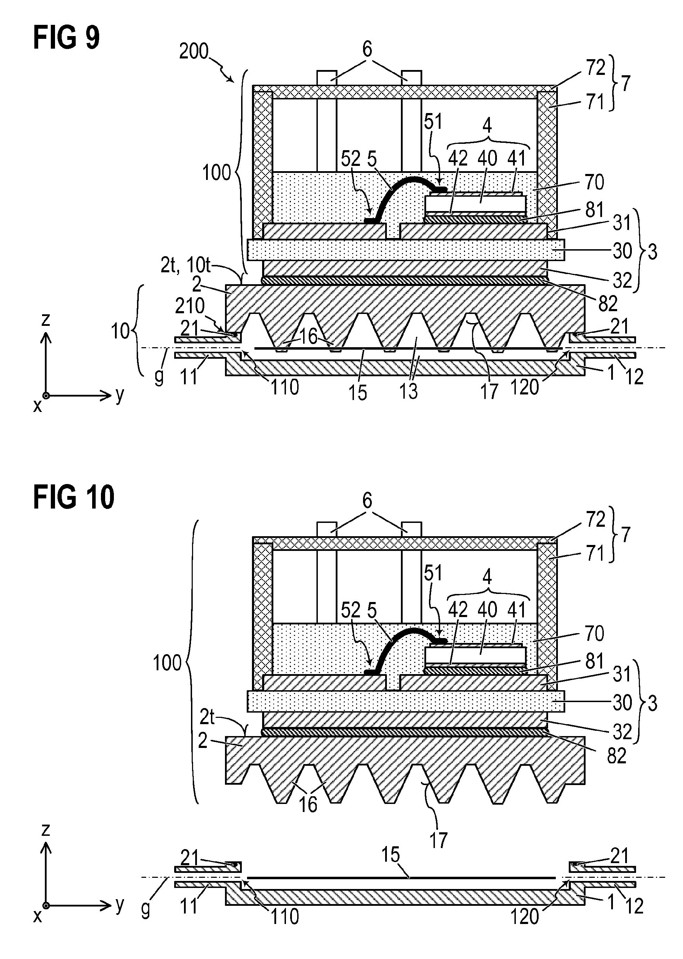

A cooler 10 as described above may be used in connection with a power semiconductor module arrangement. Figure 9 illustrates an example power semiconductor module arrangement 200 with a power semiconductor module 100 that is in thermal contact with the contact surface 10t of a cooler 10 as described with reference to Figures 1 to 8. The power semiconductor module 100 has a circuit board 3 and a semiconductor chip 4 disposed on the circuit board 3. In the power semiconductor module arrangement 200, the second part 2 is disposed between the semiconductor chip 4 and the cavity 13.

The semiconductor chip 4 has a semiconductor body 40, a first chip metallisation 41 and a second chip metallisation 42 both disposed on the semiconductor body 40. The semiconductor body 40 includes a monocrystalline or substantially monocrystalline semiconductor material, e.g., silicon, silicon carbide, gallium nitride or any other semiconductor material. The semiconductor body 40 may have one or more semiconductor regions doped with electrically active dopants, i.e. with dopants causing the respective semiconductor region to be n-doped or p-doped.

Optionally, the first and second chip metallisations 41, 42 may be disposed on opposite surfaces of the semiconductor body 40. For example, the first chip metallization 41 may be disposed on a first surface of the semiconductor body 40 facing away from the second part 2 (and from the substrate 3, if provided), and the second chip metallization 42 may be disposed on a second surface of the semiconductor body 40 facing towards the second part 2 (and towards the substrate 3, if provided). Alternatively, both the first and second chip metallisations 41, 42 may be disposed on a first surface of the semiconductor body 40. For example, the first surface of the semiconductor body 40 may be the surface facing away from the second part 2 (and from the circuit board 3, if provided). The semiconductor chip 4 may already be packaged prior to being attached to the circuit board 3, or, alternatively, be attached to the circuit board 3 as a bare semiconductor chip 4.

The semiconductor chip 4 may have a semiconductor component that has a load path formed between the first and second chip metallisations 41 and 42. The semiconductor component may be, for instance, a diode, or a controllable semiconductor component like a unipolar or bipolar transistor or a thyristor. In case of a transistor, the controllable semiconductor component may be, for instance, an IGFET (Insulated Gate Bipolar Transistor) like a MOSFET (Metal Oxide Semiconductor Field-Effect Transistor) or an IGBT (Insulated Gate Bipolar Transistor), a JFET (Junction Field Effect Transistor), a HEMT (High Electron Mobility Transistor), or any other transistor.

The first chip metallisation 41 and the second chip metallisation 42 may be a source metallisation and a drain metallisation, or a drain metallisation and a source metallisation, or an emitter metallisation and a collector metallisation, or collector metallisation and an emitter metallisation, or an anode metallisation and a cathode metallisation, or a cathode metallisation and an anode metallisation. The semiconductor component may optionally be a vertical semiconductor component with the first chip metallisation 41 and the second chip metallisation 42 disposed on opposite surfaces of the semiconductor body 40.

In case of a controllable semiconductor component, the semiconductor chip 4 has a third chip metallisation (not shown) that is disposed either on a first surface of the semiconductor body 40 facing away from the second part 2 (and away from the circuit board 3, if provided), or on a second surface of the semiconductor body 40 facing towards the second part 2 (and toward the circuit board 3, if provided). The third chip metallisation may be, for instance, a gate metallisation or a base metallisation.

Using one or more semiconductor chips 4 as described above, the semiconductor module 100 may include, for instance, a controllable semiconductor switch, a half-bridge, two half-bridges (e.g. a H-bridge), three half-bridges, multilevel circuits, or any other configuration. In a half-bridge, the load paths of two semiconductor chips 4 are electrically connected in series.

The semiconductor chip 4 is attached to the circuit board 3 using a first connection layer 81. The first connection layer 81 directly adjoins both the semiconductor chip 4 and the circuit board 3 and continuously extends there between. In order to electrically connect the semiconductor chip 4 at its second chip metallisation 42 with the circuit board 3, the first connection layer 81 may be electrically conductive and directly adjoin the second chip metallisation 42. A conductive first connection layer 81 may be, for example, a solder layer, a layer of a sintered metal powder, or a layer of an electrically conductive adhesive. If there is no requirement of electrically conductively connecting the semiconductor chip 4 at its second chip metallisation 42 with the circuit board 3, a dielectric first connection layer 81, for example a layer of a dielectric adhesive, may be used as well.

The circuit board 3 includes a dielectric insulation carrier 30, and a first circuit board metallisation layer 31 attached to the insulation carrier 30. The semiconductor chip 4 is attached to the first circuit board metallisation layer 31 so that the first circuit board metallisation layer 31 is disposed between the semiconductor chip 4 and the insulation carrier 30. Optionally, the circuit board 3 may include a second circuit board metallisation layer 32 that is attached to the insulation carrier 30 so that the dielectric insulation carrier 30 is disposed between the first circuit board metallisation layer 31 and the second circuit board metallisation layer 32. Each of the first circuit board metallisation layer 31 and, if provided, the second circuit board metallisation layer 32, may consist of or include one of the following materials: copper; a copper alloy; aluminium; an aluminium alloy; or any other metal or alloy having a good electrical conductivity.

The dielectric insulation carrier 30 may be a ceramic, for instance a thin ceramic layer. The ceramic may be, for example, composed of or include one of the following materials: aluminium oxide (Al₂O₃); aluminium nitride (AlN); zirconium oxide (ZrO₂); silicon nitride; boron nitride; or any other dielectric ceramic. The circuit board 3 may be, e.g., a DCB substrate (DCB=Direct Copper Bonding), a DAB substrate (DAB=Direct Aluminium Bonding), or an AMB substrate (AMB=Active Metal Brazing).

In the power semiconductor module arrangement 200, the circuit board 3 is disposed between the semiconductor chip 4 and the cooler 10, and the first circuit board metallisation layer 31 is disposed between the dielectric layer 30 and the semiconductor chip 4. If the circuit board 3 also includes a second circuit board metallisation layer 32, the dielectric insulation carrier 30 is disposed between the first circuit board metallisation layer 31 and the second circuit board metallisation layer 32, and the second circuit board metallisation layer 32 is disposed between the dielectric circuit carrier 30 and the cooler 10. Independently of whether or not there is a second circuit board metallisation layer 32, the semiconductor chip 4 may be galvanically insulated from the second part 2.

The semiconductor module 100 may include a bond wire 5 that is directly bonded at a first bonding location 51 to the first chip metallisation 41 and at a second bonding location 52 to any other element of the semiconductor module 100 in order to electrically connect the other element to the first chip metallisation 41. As exemplarily illustrated in Figure 9, the other element may be the first circuit board metallisation layer 31.

Optionally, the power semiconductor module 100 may have a module housing 7 that may be configured in any desired fashion. According to one example, the module housing 7 may consist of or include an electrically insulating material, for example plastic, e.g. a thermoplastic or thermoset. The module housing 7 may be embodied in an integral fashion, or else be composed of two or more housing parts 71, 72. For instance, a module housing 7 may have a ring-shaped frame 71 having side walls, and, optionally, a lid 72. The lid 72 and the ring-shaped frame 71 may be formed in an integral fashion, or else be separate parts. The semiconductor chip 4 is disposed inside the module housing 7. Optionally, the semiconductor chip 4 may be covered by a dielectric encapsulation 70, e.g. a gel, in particular a silicone gel, so that the semiconductor chip 4 is disposed between the dielectric potting 70 and the circuit board 3. The encapsulation 70 may be applied to the circuit board 3 and the semiconductor chip 4 subsequent to attaching the semiconductor chip 4 to the circuit board 3 by means of the first connection layer 81. In cases where the semiconductor chip 4 is a bare semiconductor chip 4, the encapsulation 70 may be in physical contact with the semiconductor body 40 of the semiconductor chip 4. Independently of whether or not the encapsulation 70 is in physical contact with the semiconductor body 40 of the semiconductor chip 4, the encapsulation 70 may be in physical contact with at least one of the insulation carrier 30 and the first circuit board metallisation layer 31. If the semiconductor module 100 has both a module housing 7 and an encapsulation 70, the encapsulation 70 may be disposed inside the module housing 7.

In order to allow for electrically contacting the power semiconductor module 100, it may have at least one electrical terminal 6 such as a sheet metal or a metal pin. The electrical terminal 6 is electrically connected to an electrical circuit that is disposed on the circuit board 3 and that includes the semiconductor chip 4. Further, the electrical terminal 6 is at least partially exposed so that it is accessible for electrically connecting it to a power supply or an electrical load outside the semiconductor module 100.

In order to provide for a good thermal contact between the power semiconductor module 100 and the contact surface 10t of the cooler 10, an interface layer 82 being in physical contact with both the power semiconductor module 100 and the contact surface 10t may be disposed between the power semiconductor module 100 and the contact surface 10t. The interface layer 82 may be, for instance, a thermal interface medium (TIM) like a heat conductive paste, or a connection layer that forms a material-locking joint between the power semiconductor module 100 and the contact surface 10t and, therefore, between the power semiconductor module 100 and the cooler 10. In case the interface layer 82 forms a material-locking joint between the power semiconductor module 100 and the contact surface 10t, the interface layer 82 may be, for example, a solder layer, a layer of a sintered metal powder, or a layer of an electrically conductive or an electrically insulating adhesive.

A power semiconductor module arrangement 200 as explained with reference to Figure 9 may be produced by providing a cooler 10 as explained with reference to Figures 1 to 8 and, subsequently, disposing a power semiconductor module 100 as explained with reference to Figure 9 on the contact surface 10t using the interface layer 82.

An alternative method for producing a power semiconductor module arrangement 200 having a cooler 10 as explained with reference to Figure 9 will now be described with reference to Figure 10. In this method, the power semiconductor module 100 which includes at least a base plate 2 and a semiconductor chip 4 attached to the base plate 2 is pre-fabricated. The base plate 2 of the pre-fabricated power semiconductor module 100 serves as second part 2 of the cooler 10 and is joined to the first part 1. The pre-fabricated power semiconductor module 100 may have the same design and may be produced in the same manner as the power semiconductor module 100 described with reference to Figure 9, but additionally includes a base plate 2 which is attached to the circuit board 3 using an interface layer 82. Joining the first part 1 and the base plate 2 may take place in the same manner as joining the first part 1 and the second part 2 described with reference to Figures 1 to 8. In the described alternative method, prior to joining the first part 1 and the second part / base plate 2, the power semiconductor module 100 includes at least the semiconductor chip 4 attached to the second part / base plate 2 (optionally with a circuit board 3 disposed between the semiconductor chip 4 and the contact surface 10t of the second part / base plate 2), and, optionally in each case, any of the parts of the power semiconductor module 100 described with reference to Figure 9.

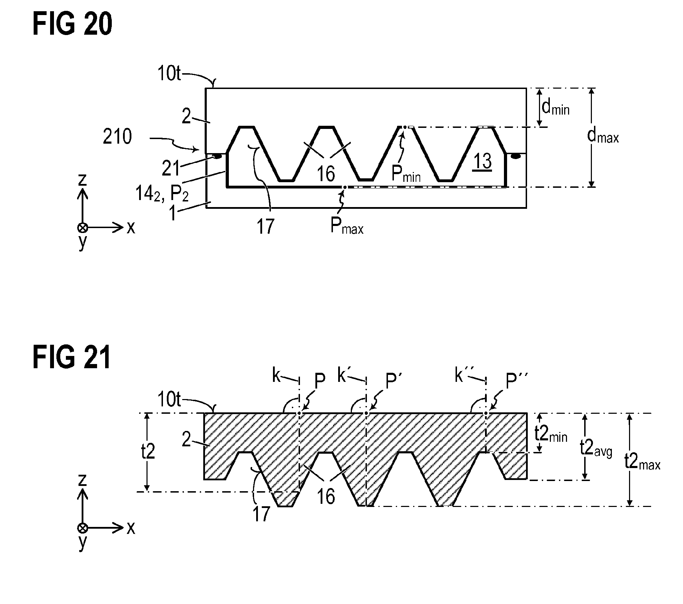

Independently from the desired method for producing a power semiconductor module arrangement 200, a first part 1 and a second part 2 of a cooler 10 may be produced as separate parts and subsequently joined with one another. Thereby, the contact surface 10t is a surface of the second part 2. As described below with reference to Figures 20 and 21, producing a second part / base plate 2 may include embossing a sheet metal.

If a power semiconductor module arrangement with a semiconductor chip 4 attached to the cooler 10 is to be produced, joining the first part 1 and the second part 2 may take place prior to or after attaching the semiconductor chip 4 (directly or with a circuit board 3 disposed between the semiconductor chip 4 and the contact surface 10t) to the contact surface 10t.

In order to increase the heat transfer between the contact surface 10t and the cavity 13, the cooler 10 may have an inner surface section 17 with a plurality of protrusions 16 extending in a direction away from the contact surface 10t. Figures 3 and 5 to 10 show an example of such a cooler having a plurality of protrusions 16 located at an inner surface section 17 of the cooler 10. In the sense of the present invention, an "inner surface" of a cooler 10 is a surface of the cooler 10 that limits the cavity 13. That is, the cavity 13 extends as far as the "inner surface" so that when the cavity 13 is completely filled with a coolant, the coolant is in physical contact with the "inner surface". Accordingly, an "inner surface section" is a section of the "inner surface". The protrusions 16 increase the surface area of the inner surface and therefore help to improve the heat exchange. As also illustrated in Figures 3 and 5 to 10, an inner surface section 17 may be disposed between the cavity 13 and the contact surface 10t. The protrusions 16 may have any shape, for example pins (having, e.g., the shape of cylinders, pyramids, truncated pyramids), or fins.

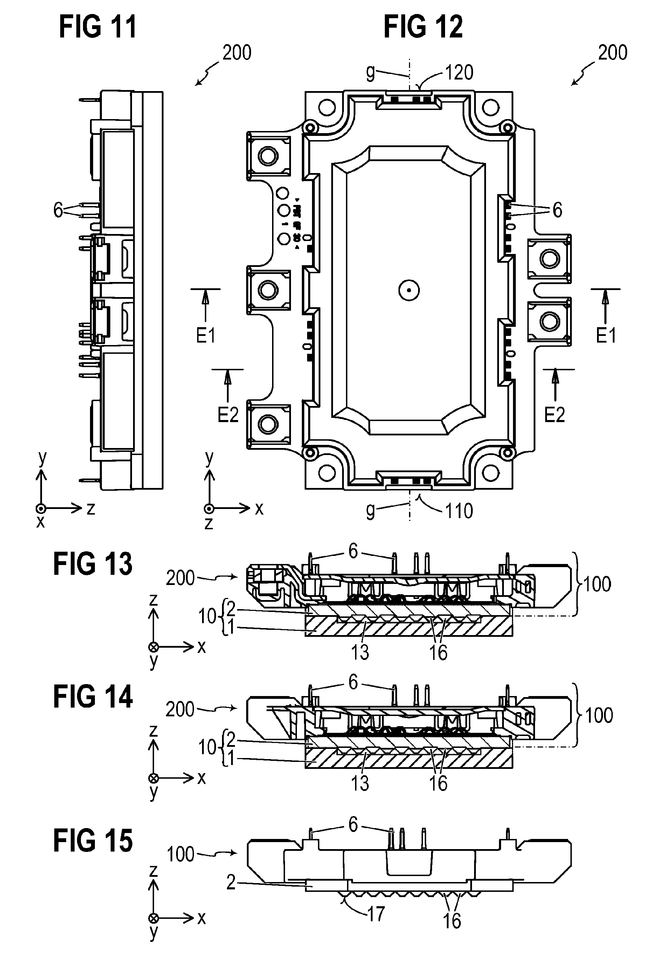

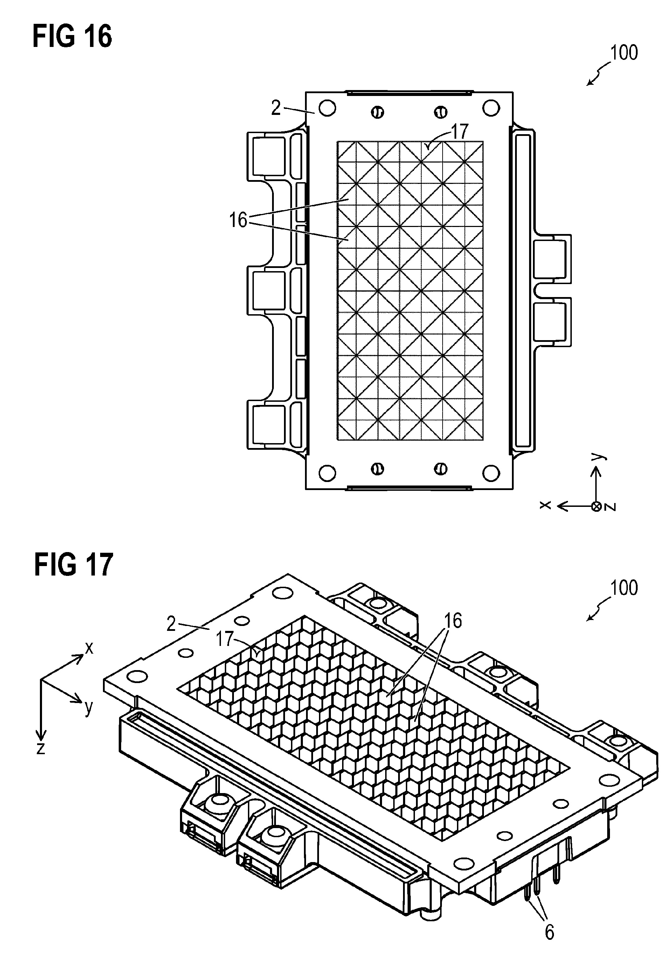

Figures 11 to 14 show different views of a further example semiconductor module arrangement 200. Figure 11 is a top view, Figure 12 is a side view (line of vision is the positive x-axis), and Figures 13 and 14 are cross-sectional side views (line of vision is the positive y-axis in each case) in sectional planes E1-E1 and E2-E2, respectively, illustrated in Figure 11. Figure 15 is a side view (line of vision is the positive y-axis in each case) of just the power semiconductor module 100 of the power semiconductor module arrangement illustrated in Figures 11 to 14 prior to being joined at its base plate 2 to a first part 1 so that the base plate 2 serves as a second part 2 of a cooler 10 as described above with reference to Figures 9 and 10. Figure 16 is a bottom view of the power semiconductor module 100 of Figure 15 with a view to the protrusions 16, and Figure 17 is an isometric view of the power semiconductor module of Figure 15 also with a view to the protrusions 16. The protrusions 16 exemplarily have shape of pyramids.

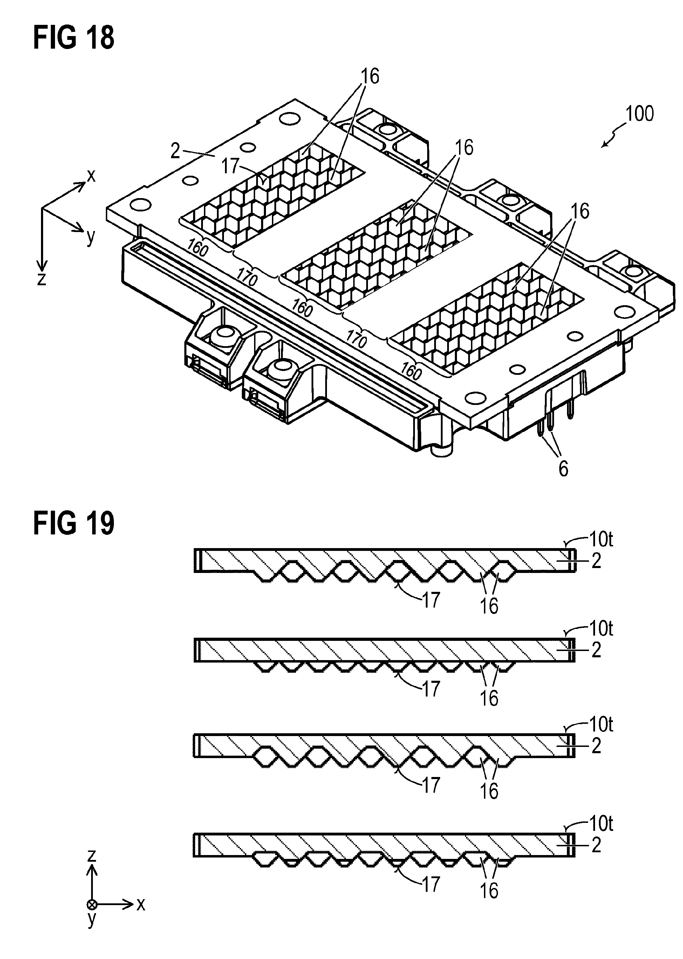

Figure 18 shows a power semiconductor module 100 that differs from the power semiconductor module 100 of Figure 17 in that the base plate 2, which may form a second part of a cooler 10, has three protrusion regions 160 separated by plane regions 170 of the surface section 17. Each of the protrusion regions 160 includes a plurality of protrusions 16 as explained above. The protrusion regions 160 may be localised opposite a semiconductor chip 4 that is joined to the contact surface 10t of the base plate / second part 2. Thereby, a circuit carrier 3 may be disposed between the respective semiconductor chip 4 and the base plate / second part 2 as described with reference to Figures 9 and 10. In the example illustrated in Figure 18, there are three protrusion regions 160. Instead, there may also be just two protrusion regions 160, or more than three protrusion regions 160 with adjacent protrusion regions 160 being separated by a plane regions 170 of the surface section 17 lying in between.

Figure 19 shows different cross sections of the same base plate / second part 2 with protrusions 16 having the shape of truncated pyramids.

A base plate / second part 2 having protrusions 16 may be produced using any suitable method, for instance by embossing, milling or casting.

In order to achieve a cooler 10 fulfilling the relation Pₘᵢₙ < Pₘₐₓ < 2·Pₘᵢₙ explained above, at least one of the length and the shape of the protrusions 16 may be adapted. In this connection, the longitudinal direction of the protrusions 16 in which the length of the protrusions 16 is to be measured, runs perpendicularly to the contact surface 10t. In the Figures, the longitudinal direction of the protrusions 16 is the direction of the z-axis.

Figure 20 shows a cross-sectional view illustrating a cross section of the cooler shown in Figure 1. The cross section is taken in a sectional planes perpendicularly intersecting the segment 15 of the straight line g (see Figure 3). In that sectional plane, the cavity 13 has a boundary line 14ⱼ limiting the cavity 13 in that sectional plane. Analogous cross sections can be taken in all sectional planes perpendicularly intersecting the segment 15 of the straight line g, and a respective boundary line 14ⱼ can be assigned to each of these sectional planes as explained with reference to Figures 6 to 8.

Among all points of all boundary lines 14j assigned to all sectional planes perpendicularly intersecting the segment 15 of the straight line g1, there is at least one point Pₘₐₓ having a maximum distance dₘₐₓ from contact surface 10t. Further, among all points of all boundary lines 14j assigned to all sectional planes perpendicularly intersecting the segment 15 of the straight line g1, there is at least one point Pₘᵢₙ having a minimum distance dₘᵢₙ from contact surface 10t. A difference dₘₐₓ - dₘᵢₙ between the maximum distance dₘₐₓ and the minimum distance dₘᵢₙ may be at least 1 mm.

It is to be noted that a contact surface 10t of a cooler 10 (which contact surface 10t may also be a mounting surface of a base plate 2 of a power semiconductor module 100 to which mounting surface a semiconductor chip 4 is mounted) may be plane or substantially plane. Alternatively however, the invention also includes uneven contact surfaces 10t.

Figure 21 shows a second part 2 of a cooler 10. As described above, the second part 2 may also serve as a base plate 2 of a power semiconductor module 100. The second part / base plate 2 has a minimum thickness t2ₘᵢₙ and a maximum thickness t2ₘₐₓ. A minimum thickness t2ₘᵢₙ of less than 0.5 mm allows for a good heat transfer between the cavity 13 and the contact surface 10t. However, a minimum thickness t2ₘᵢₙ of more than or equal to 0.5 mm may also be used. The difference t2ₘₐₓ - t2ₘᵢₙ is a measure for the length of the longest protrusions 16. For instance, the difference t2ₘₐₓ - t2ₘᵢₙ may be less than 8 mm. The thickness t2, t2ₘᵢₙ, t2ₘᵢₙ, the second part / base plate 2 has at a certain point P, P', P" of the contact surface 10t is to be measured along a straight line k, k', k" running, perpendicularly to the contact surface 10t, through the respective point P, P', P".

Optionally, the minimum thickness t2ₘᵢₙ of the second part / base plate 2 may be smaller than the average thickness t2_{avg} of the second part / base plate 2, wherein the average thickness t2_{avg} of the second part / base plate 2 is the arithmetic average of the thickness of the second part / base plate 2. A minimum thickness t2ₘᵢₙ smaller than the average thickness t2_{avg} facilitates manufacturing the second part / base plate 2 by embossing, e.g. a flat sheet metal. However, methods other than embossing may be used as well for manufacturing the second part / base plate 2. Producing a second part / base plate 2 by embossing may include embossing a flat sheet metal having plane parallel (opposite) main surfaces. Embossing plastically deforms the sheet metal on at least one of the main surfaces so that the protrusions 16 result.

Referring to both Figures 20 and 21, the difference dₘₐₓ - dₘᵢₙ is a measure for the maximum height the cavity 13 has in a direction perpendicular to the contact surface 10t. It was found that an improved cooling efficiency may be achieved for dₘₐₓ - dₘᵢₙ < 1.05·t2ₘₐₓ.

In the coolers and arrangement described above, the maximum value Pₘₐₓ of the perimeter lengths is required to be greater than the minimum value Pₘᵢₙ of the perimeter lengths. However, in order to increase an increased cooling efficiency, the maximum value Pₘₐₓ of the perimeter lengths may be greater than 1.01 times, greater than 1.1 times, greater than 1.25 times, or even greater than 1.5 times the minimum value Pₘᵢₙ of the perimeter lengths.

## Claims

1. A cooler comprising:
a cavity configured to receive a cooling fluid;
an inlet opening configured to supply the cooling fluid to the cavity;
an outlet opening for discharging the cooling fluid from the cavity;
wherein in each of all sectional planes perpendicularly intersecting a segment of a straight line running through both the inlet opening and the outlet opening, the cavity comprises a boundary line formed as a closed loop and having an individual perimeter length, and wherein a maximum value of the perimeter lengths is greater than a minimum value of the perimeter lengths and less than twice the minimum value of the perimeter lengths.

2. The cooler of claim 1, wherein the segment comprises a length of at least 10 mm.

3. The cooler of any of the preceding claims comprising a contact surface for mounting a device to be cooled, wherein:
at least one of all points of all boundary lines assigned to all sectional planes perpendicularly intersecting the segment of the straight line has a maximum distance from the contact surface;
at least one of all points of all boundary lines assigned to all sectional planes perpendicularly intersecting the segment of the straight line has a minimum distance from the contact surface; and
a difference between the maximum distance and the minimum distance is at least 1 mm.

4. The cooler of any of the preceding claims comprising a contact surface, wherein:
the cooler comprises a first part and a second part joined to the first part;
the contact surface is a surface of the second part;
at least one of all points of all boundary lines assigned to all sectional planes perpendicularly intersecting the segment of the straight line has a maximum distance from the contact surface.
at least one of all points of all boundary lines assigned to all sectional planes perpendicularly intersecting the segment of the straight line has a minimum distance from the contact surface;
the second part comprises, in a direction perpendicular to the contact surface, a maximum thickness; and
the difference between the maximum distance and the minimum distance is less than 1.05 times the maximum thickness.

5. The cooler of any of the preceding claims comprising a contact surface, wherein:
at least one of all points of all boundary lines assigned to all sectional planes perpendicularly intersecting the segment of the straight line has a minimum distance from the contact surface; and
the minimum distance is less than 0,5 mm.

6. A power semiconductor module arrangement comprising:
a cooler of any of the preceding claims; and
a semiconductor chip attached to a contact surface of the cooler.

7. The power semiconductor module arrangement of claim 6, wherein the cooler comprises a first part and a second part joined with each other.

8. The power semiconductor module arrangement of claim 7, wherein at least one of the first inlet opening and the second inlet opening is an element of the first part.

9. The power semiconductor module arrangement of any of claims 7 to 8, wherein the semiconductor chip is joined to the cooler at the second part so that the second part is disposed between the semiconductor chip and the cavity.

10. The power semiconductor module arrangement of any of claims 6 to 9 comprising a circuit board with a first circuit board metallisation layer, a second circuit board metallisation layer and a dielectric insulation carrier disposed between the first circuit board metallisation layer and the second circuit board metallisation layer, wherein:
the circuit board is disposed between the semiconductor chip and the cooler;
the first circuit board metallisation layer is disposed between the dielectric insulation carrier and the semiconductor chip; and
the second circuit board metallisation layer is disposed between the dielectric insulation carrier and the cooler.

11. The power semiconductor module arrangement of any of claims 7 to 10, wherein the semiconductor chip is galvanically insulated from the second part.

12. The power semiconductor module arrangement of any of claims 6 to 11 comprising a circuit board and a dielectric encapsulant, wherein the semiconductor chip is disposed between the circuit board and the dielectric encapsulant.

13. The power semiconductor module arrangement of claim 12, wherein the dielectric encapsulant is a gel.

14. The power semiconductor module arrangement of any of claims 12 to 13, wherein the dielectric encapsulant is in physical contact with a semiconductor material of the semiconductor chip.

15. A method for producing a power semiconductor module arrangement with a cooler, the cooler comprising a first part and a second part, the method comprising:
attaching a semiconductor chip to a base plate; and, subsequently,
joining the first part and the base plate so that the first part and the base plate form a cooler of any of claims 1 to 5 with the base plate being the second part.
